# EUROPÄISCHE PATENTSCHRIFT

(11) **EP 2 647 049 B1**
(45) Veröffentlichungstag und Bekanntmachung des Hinweises auf die Patenterteilung: **20.08.2014**
(21) Anmeldenummer: 11811519.5
(22) Anmeldetag: 19.11.2011
(51) Int. Cl.: H01L 27/142

(54) **VERFAHREN ZUR HERSTELLUNG EINES SOLARMODULS**
METHOD FOR PRODUCING A SOLAR MODULE
PROCÉDÉ DE FABRICATION D'UN MODULE SOLAIRE

(30) Priorität: 01.12.2010 DE 102010052861
(43) Veröffentlichungstag der Anmeldung: 09.10.2013
(73) Patentinhaber: Forschungszentrum Jülich Gmbh, 52425 Jülich (DE)
(72) Erfinder: BUNTE, Eerke, 52428 Jülich (DE); ZWAYGARDT, Brigitte, 52428 Jülich (DE); HAAS, Stefan, 52499 Baesweiler (DE)
(86) Internationale Anmeldenummer: PCT/DE2011/002006
(87) Internationale Veröffentlichungsnummer: WO 2012/092913

(56) Entgegenhaltungen:
- DE-A1- 4 230 338
- US-A1- 2003 213 974
- US-A1- 2010 190 275

## Beschreibung

Die Erfindung bezieht sich auf ein Verfahren zur Herstellung eines Solarmoduls.

### Stand der Technik

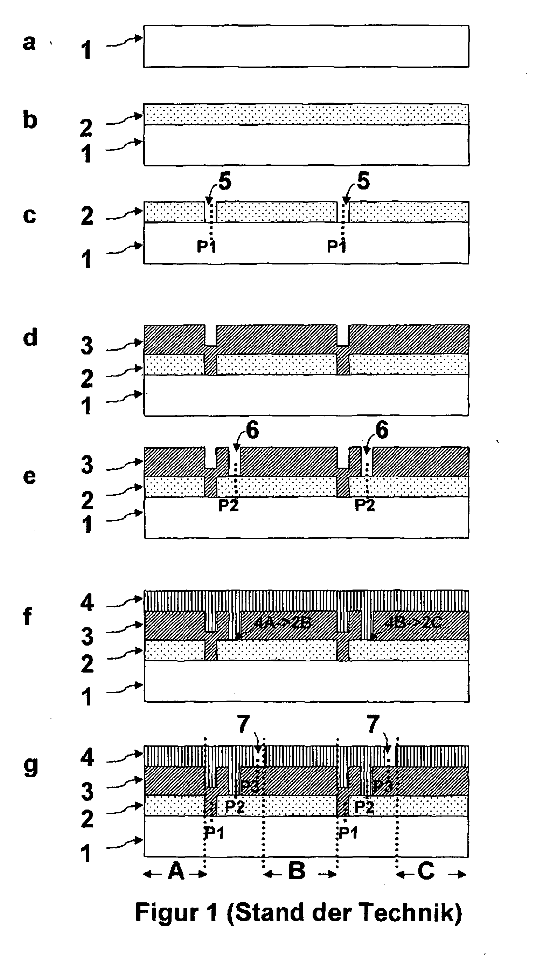

Ein bekanntes Verfahren zur Herstellung und gleichzeitigen Serienverschaltung von streifenförmigen photovoltaischen Elementen eines Solarmoduls ist in der Figur 1 grob schematisch und im Querschnitt dargestellt.

Zunächst wird eine erste elektrische Kontaktschicht, z. B. eine transparente leitfähige Schicht 2, z. B. aus ZnO oder aus SnO₂ auf ein transparentes Substrat 1 als Trägermaterial aufgebracht, siehe Figur 1b. Als Substrat wird z. B. Glas oder Folie verwendet. Eine typische Prozesstemperatur für das Aufbringen einer ZnO Schicht mittels Sputterverfahren ist 300 °C.

Anschließend werden erste Gräben 5 durch die P1-Strukturierung bei Raumtemperatur mittels Laser durch Ablation gebildet. Dabei werden parallel zueinander angeordnete erste Gräben 5 über die Länge des Moduls hergestellt (Fig. 1c).

Im Weiteren wird die Bezeichnung "über die Länge des Moduls" verwendet. Damit ist eine Strukturierung gemeint, die in der Tiefe der Blattebene der Figuren verläuft. Dabei werden die für Solarmodule mit streifenförmigen photovoltaischen Elementen charakteristischen Linien gebildet. In Aufsicht auf das fertige Solarmodul sind die Linien erkennbar.

Danach wird ein Absorberschichtsystem aus Halbleiter-Schichten 3 aufgebracht, z. B. eine a-Si/µc-Tandemsolarzelle (siehe Fig. 1d). Dabei werden die ersten Gräben 5 verfüllt. Eine typische Prozesstemperatur für das Aufbringen von Siliziumschichten mittels PECVD Verfahren beträgt 100-250°C.

Dann werden die P2-Linien wiederum durch Ablation gebildet. Parallel zu den ersten Gräben werden die zweiten Gräben 6 hergestellt und zwar in der Figur 1 immer rechts von den ersten Gräben 5.

Im Anschluss daran wird eine zweite elektrische Kontaktschicht 4 als Rückkontakt auf die Halbleiter-Schichten 3 aufgebracht, z. B. ein ZnO/Ag-Kontakt, siehe Fig. 1f. Dabei werden die zweiten Gräben 6 verfüllt. Eine typische Prozesstemperatur für das Aufbringen eines ZnO/Ag Rückkontakts mittels Sputterverfahren ist die Raumtemperatur.

Anschließend wird wiederum mit einem Laser die P3 Linie hergestellt, siehe Fig. 1g. Dabei werden dritte Gräben 7 parallel und im Bild immer rechts von den ersten und zweiten Gräben gebildet. Es entstehen also jeweils gleich viele Gräben 5, 6 und 7. Damit ist die Serienverschaltung der Zelle A mit der Zelle B und die der Zelle B mit der Zelle C und so fort abgeschlossen.

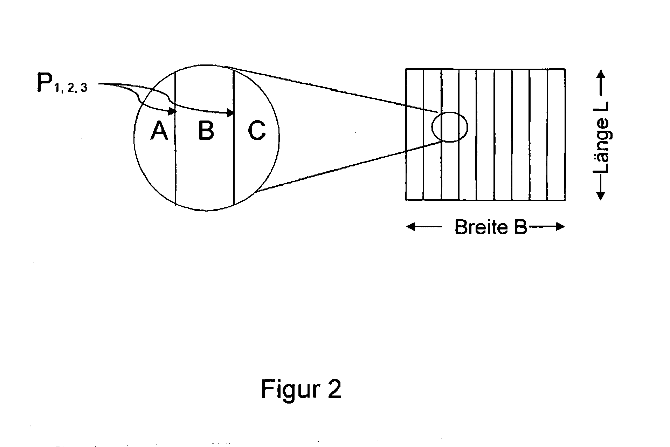

Figur 2 zeigt in Aufsicht und schematisch ein auf diese Weise hergestelltes Modul nach dem Stand der Technik. Die Länge L und die Breite B sind angegeben. Je 8 vertikale Linien im Innern trennen die insgesamt 9 streifenförmigen photovoltaischen Elemente voneinander. Im linken Teil der Figur 2 ist eine Ausschnittvergrößerung im Bereich der Zellen A, B und C gezeigt. In der Ausschnittvergrößerung entspricht die senkrechte Linie zur Trennung der Zelle A von der Zelle B sowie die senkrechte Linie zur Trennung der Zelle B von der Zelle C der schematischen Darstellung der drei parallel nebeneinander angeordneten Gräben 5 bis 7 in der Figur 1. Die Begriffe Länge L und Breite B werden in diesem Sinne in der Patentan-meldung verwendet.

Es ist im Übrigen bekannt, dass ZnO als Material der ersten elektrischen Kontaktschicht 2 in Säure oder in Lauge ätzbar ist. Die Ätzung erfolgt zur Aufrauung der Oberfläche des ZnO 2 mit einem nasschemischen Ätzprozess, z. B. mit Salzsäure. Dabei werden Krater in der Oberfläche des ZnO gebildet. Die Aufrauung der ZnO-Schicht bewirkt eine bessere Lichteinkopplung und Lichtstreuung des eingefangenen Lichts in die Halbleiter-Schichten.

Die US 2010/190275 A1 offenbart ein Verfahren zur Herstellung und Serienverschaltung eines Solarmoduls mit streifenförmigen photovoltaischen Elementen über die Länge des Solarmoduls, bei dem auf einem Substrat eine erste elektrische Kontaktschicht angeordnet wird, auf dieser ersten elektrischen Kontaktschicht aktive Halbleiterschichten angeordnet werden und auf den aktiven Halbleiterschichten eine zweite elektrische Kontaktschicht angeordnet wird.

Nachteilig sind die beschriebenen Verfahren zur Herstellung und gleichzeitigen Serienverschaltung der streifenförmigen Elemente langsam und ineffizient.

### Aufgabe und Lösung der Erfindung

Aufgabe der Erfindung ist es, ein schnelleres und vereinfachtes Verfahren zur Herstellung und Serienverschaltung von Solarmodulen mit streifenförmigen photovoltaischen Elementen anzugeben. Eine weitere Aufgabe der Erfindung ist es, ein entsprechendes Solarmodul bereit zu stellen.

Die Aufgabe wird durch ein Verfahren nach Anspruch 1 und durch das Modul gemäß dem Nebenanspruch gelöst. Vorteilhafte Ausgestaltungen ergeben sich aus den jeweils darauf rückbezogenen Ansprüchen.

### Beschreibung der Erfindung

Das Verfahren zur Herstellung des Solarmoduls sieht die nachfolgenden Schritte vor:

Auf einem Substrat wird ganzflächig eine erste elektrische Kontaktschicht angeordnet, und auf der ersten elektrischen Kontaktschicht werden ganzflächig die aktiven Halbleiterschichten angeordnet. Anschließend wird die zweite elektrische Kontaktschicht aufgebracht. Vorteilhaft werden dadurch nacheinander bereits mindestens fünf Schichten ganzflächig abgeschieden, ohne dass die Abscheidung von Schichten als solche unterbrochen wird. Im Rahmen der Erfindung wurde erkannt, dass das aus dem Stand der Technik bekannte Verfahren deshalb langsam und ineffizient ist, weil für jeden Ablationsschritt die bereits prozessierte Schichtenfolge wieder auf Raumtemperatur abgekühlt werden muss. Erst danach werden dann die verbleibenden, noch fehlenden Schichten angeordnet.

Alle Schichten des erfindungsgemäßen Verfahrens werden vorzugsweise ganzflächig nacheinander angeordnet. Auf eine aufwändige Maskentechnologie zur streifenförmigen Strukturierung wird vorteilhaft dadurch verzichtet.

Als Substrat kommt insbesondere Glas, Kunststofffolie oder ein Metall mit einer isolierenden Schicht in Betracht.

Das Material der ersten elektrischen Kontaktschicht ist selektiv ätzbar. Selektiv ätzbar im Sinne der Erfindung bedeutet, dass das Material der ersten elektrischen Kontaktschicht auch seitlich, das heißt unter den Halbleiter-Schichten unterätzbar ist. Daneben weist das Material eine gute Leitfähigkeit auf. Hierfür kommen insbesondere aber nicht ausschließlich ZnO:Al, ZnO:B, Indiumzinnoxid (ITO) oder TiO₂ sowie Legierungen, wie z. B. ZnMgO, in Frage. Ferner können SnO₂ oder Metalle eingesetzt werden. Mögliche Verfahren zur Anordnung der ersten Kontaktschicht sind die dem Fachmann bekannten Verfahren, wie z. B. Sputtern, Aufdampfen und PECVD-Verfahren.

Als Halbleiter-Schichten sind alle Schichten zum Aufbau für Solarzellen vorgesehen. Die Erfindung ist diesbezüglich nicht eingeschränkt. Insbesondere können eine a-Si:H-µc-Si:H-Tandemsolarzelle oder eine andere Schichtenfolge, wie sie üblicherweise in der Solarzellenindustrie oder auch in der TFT-Technologie genutzt werden, angeordnet werden. Hierunter fallen p-i-n- oder p-i-n-p-i-n-Schichtenfolgen oder n-i-p- oder n-i-p-n-i-p-Schichtenfolgen.

Mögliche Halbleiterschichtsysteme sind ferner amorphes, mikrokristallines, polykristallines Silizium, Siliziumgermanium, Siliziumkohlenstoff, SiO₂, Si₃N₄, SiOx, SiON, CdTe und CIGS. Auch können organische Materialien eingesetzt werden. Es können vorteilhaft auch p-i-n-Dioden aus a-Si oder µc-Si oder auch Tandemstrukturen aus a-Si/a-Si oder auch a-Si/µc-Si und den jeweiligen Legierungen des Siliziums mit Germanium oder Kohlenstoff übereinander angeordnet werden.

Auf den aktiven Halbleiter-Schichten wird zum Aufbau einer funktionsfähigen Schichtenfolge eine zweite elektrische Kontaktschicht ganzflächig angeordnet. Mögliche Beschichtungsmethoden für die zweite Kontaktschicht sind wiederum Sputtern, Aufdampfen und PECVD-Verfahren. Die zweite elektrische Kontaktschicht sollte aus einem anderen Material als die erste elektrische Kontaktschicht bestehen, und ist nicht ätzbar im Sinne der Erfindung. Die zweite elektrische Kontaktschicht kann aus Silber, Aluminium, Chrom, Nickel, ZnO:Al, ZnO:B, Ti02, SnO₂, ITO oder einer Kombination, z. B. aus ZnO:Al und Silber oder Aluminium, oder auch aus ITO und Silber auf den Halbleiter-Schichten abgeschieden werden.

Zur Ausbildung serienverschalteter, paralleler, streifenförmiger photovoltaischer Elemente werden folgende Schritte durchgeführt:
1. Es wird die Oberfläche der ersten elektrischen Kontaktschicht über die Länge des Moduls perforationsartig freigelegt. Vorteilhaft bewirkt diese Vorgehensweise, dass nacheinander alle Schichten abgeschieden werden können, ohne dass zur Bildung und Serienverschaltung die Abscheidung als solches unterbrochen werden muss und die Schichtenfolge der Abscheidungskammer entnommen werden muss. Für den Verfahrensschritt wird vorzugsweise ein Laser gewählt. Es werden dabei so viele parallele Perforationslinien P1 über die Länge des Moduls gebildet, wie erste Gräben zur Bildung streifenförmiger photovoltaischer Elemente gebildet werden sollen.
2. Die Schichtenfolge wird einer Ätzlösung ausgesetzt, bei dem das Material der ersten elektrischen Kontaktschicht geätzt wird. Die zweite elektrische Kontaktschicht sowie die Halbleiter-Schichten werden gar nicht geätzt oder allenfalls in einer für die Funktionsweise der Solarzelle unerheblichen Weise am Rand der Solarzelle geätzt. Es wird also entsprechend eine Ätzlösung für das Material der ersten elektrischen Kontaktschicht gewählt. Es kommt zum Unterätzen von Bereichen unter der Absorberschicht. Der Ätzschritt wird solange fortgesetzt, bis sich benachbarte unterätzte Bereiche berühren. Vorteilhaft wird der Ätzschritt zur Bildung erster Gräben solange fortgesetzt, bis zwischen den Halbleiter-Schichten und dem Substrat über die Länge des Moduls die ersten Gräben parallel nebeneinander ausgebildet sind. Es werden auf diese Weise benachbarte Gräben ausgebildet, z. B. etwa 8 bis 10 erste Gräben in einem 10x10 cm² Solarmodul zur Ausbildung von 8 bis 10 streifenförmigen photovoltaischen Elementen. Die ersten Gräben weisen etwa einen Abstand im cm-Maßstab zueinander auf. Diese Bildung erster Gräben wird im Weiteren auch als P1-Strukturierung bezeichnet. Vorteilhaft ist die erste elektrische Kontaktschicht zweier benachbarter Zellstreifen nach dem Ätzprozess elektrisch voneinander getrennt.
3. Es werden eng benachbart im µm-Maßstab, z. B. 200 µm entfernt, und seitlich versetzt parallel zu den ersten Gräben gleich viele zweite Gräben über die Länge des Moduls gebildet, wobei in den zweiten Gräben die Oberfläche der ersten elektrischen Kontaktschicht freigelegt ist. Dieser Schritt dient der Unterteilung in streifenförmige photovoltaische Elemente. Der Schritt wird im Weiteren auch als P3-Strukturierung bezeichnet.
4. Sodann wird zwischen den ersten Gräben und den zweiten Gräben jeweils ein elektrischer Kontakt von der zweiten elektrischen Kontaktschicht eines streifenförmigen photovoltaischen Elementes (A) zu der ersten elektrischen Kontaktschicht eines hierzu unmittelbar benachbarten streifenförmigen photovoltaischen Elementes (B) gebildet, vorzugsweise durch Laserablation.

Es kann vorzugsweise eine Ablation jeweils zwischen den ersten und zweiten Gräben durchgeführt werden. Die Ablation bewirkt vorteilhaft, dass durch das Aufschmelzen des Materials der Schichten ein linienförmiger elektrischer Kontakt über die Länge des Moduls von der zweiten elektrischen Kontaktschicht eines ersten streifenförmigen photovoltaischen Elements (A) zu der ersten elektrischen Kontaktschicht eines zweiten streifenförmigen photovoltaischen Elements (B) jeweils zwischen den ersten und den zweiten Gräben gebildet wird. Damit erfolgt vorteilhaft die Serienverschaltung benachbarter streifenförmiger photovoltaischer Elemente durch Kontaktbildung zwischen den beiden Gräben. Dieser Schritt wird im Weiteren daher als P2-Strukturierung bezeichnet.

Die P2-Strukturierung kann auch wie folgt hergestellt werden. Mittels einer Laserablation mit einem Laser der Wellenlänge 532 nm werden zwischen den ersten und zweiten Gräben jeweils dritte Gräben hergestellt. Dabei werden die zweite elektrische Kontaktschicht und die Halbleiter-Schichten zwischen den ersten und den zweiten Gräben jeweils entfernt und die Oberfläche der ersten elektrischen Kontaktschicht freigelegt. Die Serienverschaltung erfolgt durch Auffüllen der so hergestellten dritten Gräben mit elektrisch leitfähigem Kontaktmaterial, z. B. leitfähiger Tinte mit Silber als Kontaktmaterial.

Es ist möglich die Gräben auch photolithographisch mit Masken und Ätzlösungen herzustellen.

Die Schritte 1. und 2. werden nacheinander zuerst durchgeführt. Die Schritte 3. und 4. danach können miteinander vertauscht werden.

Das erfindungsgemäße Verfahren verhindert vorteilhaft eine zeit- und kostenintensive Unterbrechung der Abscheidungen der Materialien.

Die Schichtenfolge soll vorteilhaft in einer Säure geätzt werden, die so stark ist, dass das Verfahren möglichst schnell zur Ausbildung der ersten Gräben führt. Beispielweise kann 2%-ige Salzsäure für 100 Sekunden angewendet werden. Selbstverständlich kann auch eine andere Säure wie Flusssäure, Schwefelsäure, Salpetersäure und auch Kalilauge verwendet werden. Die Ätzzeit hängt neben der Wahl der Säure dabei maßgeblich von den Einstellungen des Lasers für die Perforation der P1-Strukturen ab, da hiermit der Abstand der einzelnen Löcher in der Perforationslinie zueinander festgelegt wird. Der Abstand von Rand-zu-Rand zweier benachbarter Löcher, die sogenannte Stegbreite S zwischen den Löchern, sollte 10 µm nicht überschreiten. Dies bewirkt vorteilhaft, dass schnelle Ätzungen in der ersten elektrischen Kontaktschicht zur Herstellung der ersten Gräben vorgenommen werden können.

Andere Säuren, wie Flusssäure oder auch Laugen, können in Abhängigkeit von der Art des Materials der ersten elektrischen Kontaktschicht als Ätzmedium eingesetzt werden.

Das Verfahren kann daher mit identischem Wirkmechanismus des Ätzschritts insbesondere eingesetzt werden bei der Herstellung und gleichzeitigen Serienverschaltung streifenförmiger Elemente zu einem Solarmodul. Auch dabei werden vorteilhaft zunächst der erste elektrische Kontakt und die Halbleiter-Schichten und der zweite elektrische Kontakt ganzflächig nacheinander angeordnet. Dadurch wird das Verfahren besonders schnell, im Vergleich zum Stand der Technik.

Im Bereich der Löcher wird durch das seitliche Unterätzen Material der ersten elektrischen Kontaktschicht unter den Halbleiter-Schichten lateral in der Breite (siehe Figur 2) sowie über die Länge des Moduls entfernt. Je mehr die dadurch gebildeten ersten Gräben unterhalb der Halbleiter-Schichten durch das seitliche Unterätzen und durch Abtrag der ersteh elektrischen Kontaktschicht lateral verbreitert werden, desto mehr Totvolumen wird im Modul erzeugt.

Es werden benachbart und seitlich versetzt zu den ersten Gräben der ersten P1-Stzukturierung durch die P3-Strukturierung zweite Gräben gebildet. Die zweiten Gräben werden parallel in derselben Ausrichtung zu den ersten Gräben gebildet. Hierzu wird vorzugsweise ein Laser verwendet. Jeweils ein erster und hierzu unmittelbar benachbarter zweiter Graben sind paarweise einander zugeordnet und trennen die photovoltaischen Elemente. Die zweiten Gräben müssen im Querschnitt gesehen bis zur Oberfläche der Halbleiter-Schichten führen. Die zweiten Gräben werden vorzugsweise eng benachbart zu den ersten Gräben gebildet. Mit eng benachbart sind vorzugsweise wenige Mikrometer Abstand der parallelen ersten und zweiten Gräben zueinander umfasst. Der Abstand muss aber mindestens so groß sein, dass mittels einer P2-Laserablation eine Kontaktbildung zwischen den ersten und zweiten Gräben erfolgen kann (siehe Schritt 4.). Zwischen den paarweise zugeordneten ersten und zweiten Gräben werden die gewünschten Kontakte zur Serienverschaltung von der zweiten elektrischen Kontaktschicht eines ersten streifenförmigen Elements, z. B. eines Elements A, zu der ersten elektrischen Kontaktschicht eines hierzu benachbarten zweiten streifenförmigen Elements, z. B. eines Elements B, und so weiter gebildet. Die linienartige P2-Strukturierung zur Kontaktbildung erfolgt dabei entsprechend der Anzahl der ersten und zweiten Gräben zwischen den ersten und den zweiten Gräben.

Die ersten und zweiten Gräben sowie der Kontakt nach der P2-Strukturierung werden vorzugsweise alle durch Laserablation hergestellt.

Die ersten Gräben nach Schritt 1. werden durch stellenweise Ablation der Halbleiter-Schichten und der zweiten elektrischen Kontaktschicht erzeugt. Für den Laserprozess kommt z. B. ein Nd:YVO₄-Laser der Wellenlänge 532 nm zum Einsatz. Dieser Laser abladiert stellenweise die Halbleiter-Schichten und den zweiten elektrischen Kontakt. Die Parameter für den Laser sind wie folgt. Die Frequenz kann 5 kHz betragen. Bei 5 kHz und 13,5 A ergibt sich eine mittlere Laserleistung von 80 mW. Die Geschwindigkeit mit der der Laser über die Schichten bewegt wird beträgt vorzugsweise 350 - 425 mm/s. Der Pulsdurchmesser beträgt z. B. 60 - 80 µm bei einer Pulsdauer von 10 ns. Die erzeugten Löcher weisen einen Abstand in der Schichtenfolge von Mittelpunkt zu Mittelpunkt von etwa 70 µm - 85µm auf. Die Stegbreite S, das heißt der Abstand von benachbarten Rändern zwischen zwei benachbarten Löchern in einer Perforationslinie beträgt auf diese Weise 5µm bis 10µm. Beispielsweise ergibt sich bei einer Frequenz von 5 kHz und einer Geschwindigkeit von 350 mm/s ein Abstand der Löcher von 70 µm. Bei einem Pulsdurchmesser von 60 µm beträgt die Stegbreite folglich 10 µm und so weiter.

Die zweiten Gräben werden durch Ablation der zweiten elektrischen Kontaktschicht und der Halbleiter-Schichten erzeugt. Hierzu kommt in der Regel ein Laser der Wellenlänge 532 nm während der P3-Strukturierung zum Einsatz.

Die Kontaktbildung zur P2-Strukturierung wird z. B. mittels Laser mit 1064 nm Wellenlänge erzeugt. Bei der P2-Strukturierung wird das gesamte Schichtsystem durch Energieeintrag in die Siliziumschichten und in die Front-TCO-Schicht, das heißt der ersten elektrischen Kontaktschicht zwischen den Gräben, aufgeheizt. Hierbei entsteht in der Mitte des bestrahlten Bereichs eine so hohe Temperatur, dass sowohl Silizium als auch der Rückkontakt, das heißt der zweite elektrische Kontakt, lokal durch thermische Ausdehnung und Verdampfung entfernt werden. Im Randbereich des so entstandenen Grabens hingegen bildet sich ein hoch leitfähiger Kontakt zwischen Frontkontakt und Rückkontakt aus. Dieser entsteht wahrscheinlich durch Aufschmelzen des Silizium-Rückkontakt-Systems. Dieses erstarrt anschließend in einer leitfähigen Mischphase. Für das Aufschmelzen müssen die Laserparameter so eingestellt werden, dass als Pulsdauer ein Dauerstrichlaser, das heißt ohne Pulsung eingestellt wird. Dabei wird auch ein Graben gebildet.

Die Kontaktbildung kann auf andere Weise durch Laserablation von Schichten und anschließender Auffüllung der Gräben mit leitfähiger Tinte erfolgen.

Alle Ablationsschritte können durch das Substrat von der Glasseite hindurch erfolgen.

Das Modul ist dadurch gekennzeichnet, dass unter den Halbleiter-Schichten durch seitlichen Unterätz gebildete erste Gräben in der ersten elektrischen Kontaktschicht über die Länge des Moduls vorhanden sind. Die Ätzgräben unterscheiden sich von durch Laserablation gebildeten Gräben durch die Ausbildung von Ätzhöfen um die Löcher herum.

### Spezieller Beschreibungsteil

Im Weiteren wird die Erfindung an Hand von Ausführungsbeispielen und der beigefügten Figuren näher beschrieben, ohne dass es hierdurch zur Einschränkung der Erfindung kommen soll.

Es zeigen:
- Figur 1:: Herstellung und Serienverschaltung streifenförmiger photovoltaischer Elemente nach dem Stand der Technik.
- Figur 2:: Aufsicht auf ein Solarmodul zur Erläuterung der Länge und Breite des Moduls.
- Figur 3:: Herstellung und Serienverschaltung streifenförmiger photovoltaischer Elemente nach der Erfindung.
- Figur 4:: Aufsicht auf das Substrat nach Herstellung der ersten Gräben mittels Ätzung.
- Figur 5:: Aufsicht auf die zweite elektrische Kontaktschicht nach Herstellung der ersten Gräben mittels Ätzung.

### Erstes Ausführungsbeispiel - Herstellung und Serienverschaltung eines Solarmoduls

Ein 10x10 cm² großes Glassubstrat 1 (Corning, Eagle XG) wird mittels Kathodenzerstäubung ("Sputtern") mit aluminiumdotiertem Zinkoxid (ZnO:A1) 2 beschichtet, welches der Solarzelle als Frontelektrode dient. Das Substrat 1 wird ganzflächig mit der ersten elektrischen Kontaktschicht 2 beschichtet. Die Anregungsfrequenz beträgt 13,56 MHz in einer Depositionsanlage VISS 300 von Von Ardenne Anlagentechnik (VAAT). Ein keramisches Target mit 1% (wt) Aluminiumoxidgehalt (Al₂O₃) in ZnO wurde gewählt. Die Substrattemperatur beträgt 300°C bei einer Entladungsleistung von 1,5 kW. Der Argon Depositionsdruck beträgt 0,1 Pa. Die Schichtdicke der Schicht 2 nach der Abscheidung beträgt etwa 800 nm. Nach Abkühlen des beschichteten Substrats 1 auf Raumtemperatur wird die Schichtenfolge mit der ersten elektrischen Kontaktschicht 2 für 30 - 50 Sekunden in verdünnter Salzsäure (0,5% wt) geätzt. Dieser Ätzschritt dient der aus dem Stand der Technik bekannten Aufrauung der Schicht 2 und ist nicht der erfindungsgemäße Ätzschritt zur Bildung der ersten Gräben. Nach der Texturierung beträgt die Schichtdicke etwa 650 nm. Die Ätzung wurde bei 25°C ausgeführt.

Anschließend werden ganzflächig die Halbleiter-Schichten 3, hier eine Halbleiter-Schichtenfolge zur Ausbildung einer amorphen Solarzelle, mittels PECVD aufgebracht. Insgesamt werden dabei drei Schichten 3 nacheinander abgeschieden. Zusammen mit der ersten elektrischen Kontaktschicht 2 werden somit insgesamt vier Schichten ganzflächig nacheinander auf dem Substrat abgeschieden.

Danach wird der Rückkontakt als zweite elektrische Kontaktschicht 4 wiederum ganzflächig mittels Sputterverfahren aufgebracht. Konkret kam ein Rückkontakt aus 80 nm ITO (Indiumzinnoxid) und 200 nm Silber zum Einsatz. Vorteilhaft wären auch die Materialien SnO₂, TiO₂ ZnO und Aluminium. Vorteilhaft weist das Material der ersten elektrischen Kontaktschicht eine höhere Ätzgeschwindigkeit im gewählten Ätzmedium auf, als die an der zweiten elektrischen Kontaktschicht beteiligten Materialien.

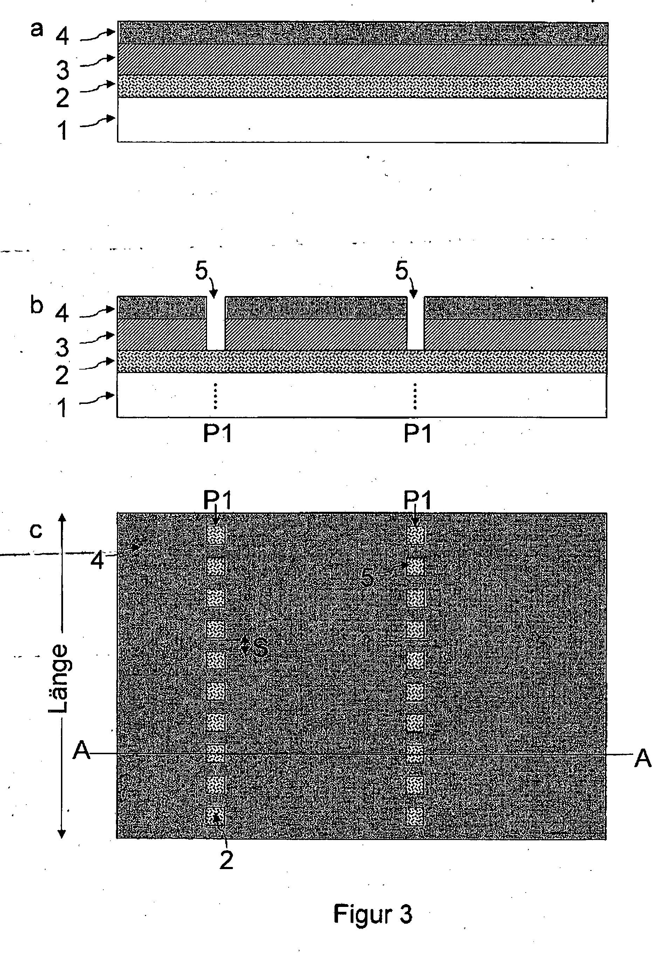

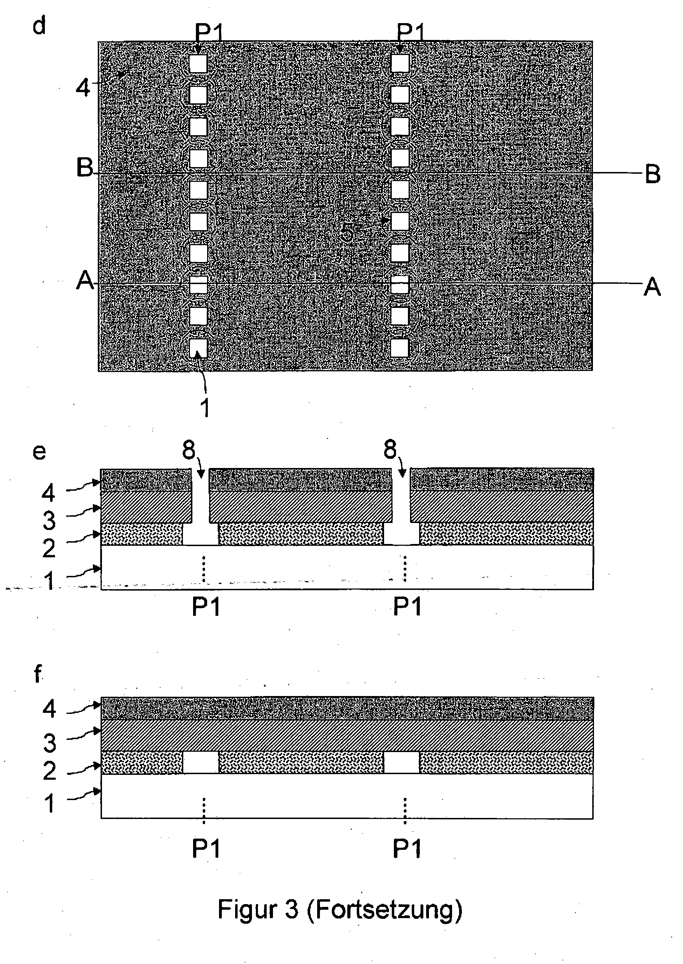

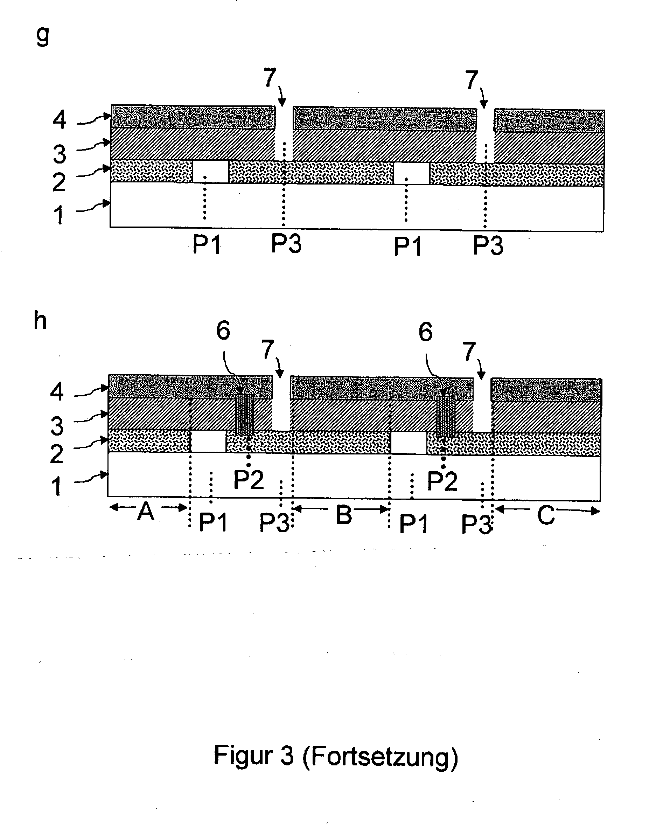

Sodann werden zur Bildung der ersten Gräben mit einem Nd:YVO₄-Laser der Wellenlänge 532 nm die ersten Gräben perforationsartig angelegt und Löcher 5 von der Substratseite her durch Ablation gebildet, siehe die P1-Strukturierung (Figur 3b, c). 10 Löcher 5 sind schematisch in der Figur je Perforationslinie P1 gezeigt. Es werden auf diese Weise acht parallel angeordnete erste Gräben 8 über die Breite des Moduls angelegt, von denen in der Figur 3 lediglich zwei angegeben sind. Figur 3b zeigt im Querschnitt den Schnitt A-A der Figur 3c. In Aufsicht ist in den abladierten Löchern 5 die erste elektrische Kontaktschicht 2 (Figur 3c) erkennbar. Jedes durch Laserpuls erzeugte Loch 5 der Perforation hat einen Durchmesser von etwa 80 µm. Der laterale Abstand der beiden dargestellten Perforationslinien zueinander beträgt etwa 1 cm.

Mittels der Laserablation P1 werden die Halbleiter-Schichten 3 sowie der Rückkontakt 4 auf einmal entfernt. Hierzu kommen folgende Laserparameter zum Einsatz. Die Frequenz beträgt 5 kHz; die Geschwindigkeit des Lasers beträgt 425 mm/s bei einer Leistung von 80 mW. Der Pulsdurchmesser beträgt 80 µm und die Pulsdauer 10 ns. Die Stegbreite S zwischen zwei benachbarten Löchern beträgt dann etwa 5 µm. Dies ist für den Abstand S zweier Löcher 5 exemplarisch dargestellt (Fig. 3c).

Danach wird die freigelegte Oberfläche der ersten elektrischen Kontaktschicht 2 dem erfindungsgemäßen Ätzschritt für etwa 100 Sekunden in 2%-iger Salzsäure unterzogen. Die Schichtenfolge wird hierzu in ein Salzsäurebad getaucht. Dieser Schritt führt zum seitlichen Unterätzen der Halbleiter-Schichten 3 und zur Ausbildung der ersten Gräben 8 in der ersten elektrischen Kontaktschicht 2. Der Schritt ist in Aufsicht, das heißt von der Rückseite her betrachtet der Figur 3d zu entnehmen. Die gestrichelten Kreise um die Löcher 5 sollen den Bereich der Unterätzung andeuten. In Aufsicht von der Rückseite ist dieser Bereich nur schwach zu sehen, es sei denn die zweite elektrische Kontaktschicht 3 wird aus transparentem oder semi-transparentem Material ausgeführt. Die Figur 3d ist die schematische Aufsicht von der Rückseite her betrachtet auf die Schichtenfolge nach der Bildung der so gebildeten, über die Länge des Moduls verlaufendenen ersten Gräben 8. In Aufsicht auf die Löcher 5 ist das Material der ersten elektrischen Kontaktschicht 2 weggeätzt, so dass das Material des Substrats 1 darin erscheint (Figur 3d). Der Schnitt A-A der Aufsicht entlang der Löcher zweier benachbarter erster Gräben ist im Weiteren in der Figur 3e im Querschnitt gezeigt. Durch den Ätzschritt ist es zu einer Aufweitung der Lochgeometrie in der Schicht 2 gekommen. Die Stege aus Material der ersten elektrischen Kontaktschicht 2 zwischen den Löchern einer Linie P1 sind selbständig weggeätzt worden. Figur 3f zeigt den Schnitt B-B der Figur 3d schematisch im Querschnitt. Danach sind über die Länge des Moduls (vergleiche Figur 2 zur Länge und Breite) verlaufende erste Gräben 5 in der ersten elektrischen Kontaktschicht 2 gebildet worden.

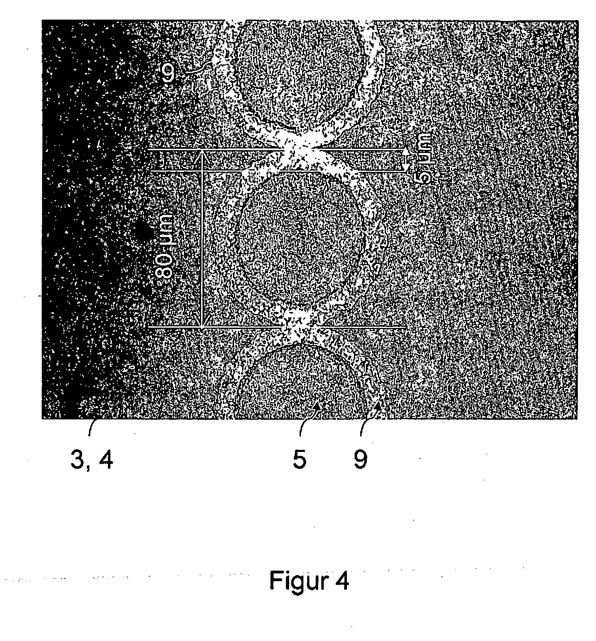

Figur 4 zeigt eine entsprechende Aufnahme in Aufsicht von der Substratseite her betrachtet. Das Glassubstrat ist transparent, ebenso die erste elektrische Kontaktschicht. Zu sehen sind daher die Halbleiterschichten 3 sowie die Perforationslöcher 5. Der Graben über die Länge des Moduls wurde durch lokales Ätzen der ersten elektrischen Kontaktschicht gebildet. Der Hof (oder Kranz) 9 ist ein ringförmiger Bereich um die Perforationslöcher 5. Auch hier ist das Material der Halbleiterschichten zu sehen. Der optische Kontrast gegenüber der umgebenden Fläche entsteht durch das Fehlen der ersten elektrischen Kontaktschicht. Die Breite des Hofs entspricht hier etwa 5 µm. Die Stegbreite zwischen den Löchern beträgt ca. 8 µm.

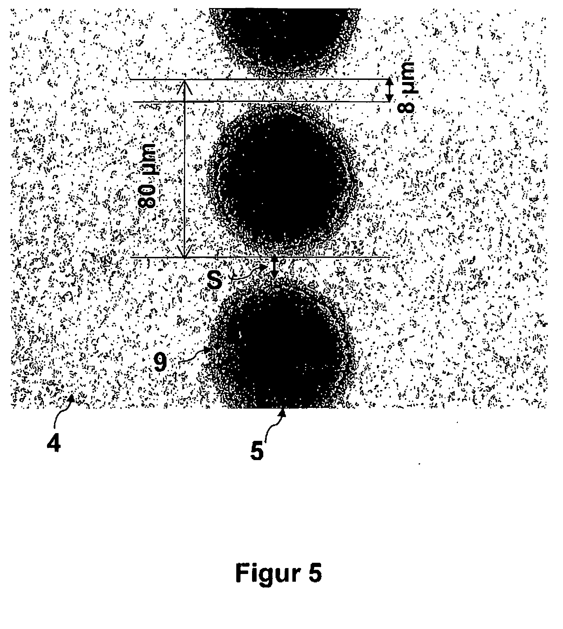

Figur 5 zeigt eine entsprechende Aufnahme in Aufsicht von der Rückseite her betrachtet. Neben den Perforationslöchern 5 und den Stegen S zwischen den Perforationslöchern 5 ist die zweite elektrische Kontaktschicht 4 zu sehen. Der Hof (Kranz) 9 um die Perforationslöcher ist aufgrund der nicht transparenten zweiten Kontaktschicht 4 nur schwach als Schatten zu erahnen.

Anschließend wird der Rückkontakt 4 und die Halbleiterschichten 3 durch eine Laserablation mit 532 nm (P3) linienartig über die Länge des Moduls vollständig aufgetrennt (siehe Figur 3g). Dabei entstehen die Gräben 7 parallel zu den ersten Gräben 8.

Danach wird durch Aufschmelzen des Absorbermaterials mittels Laserbeschuss im Bereich P2 eine leitfähige Verbindung 6 zwischen Front- und Rückkontakt geschaffen. Die beiden zuletzt genannten Prozessschritte sind in ihrer Reihenfolge vertauschbar. Das Ergebnis des in Serie verschalteten Bauelements zeigt Figur 3h. Für das Aufschmelzen kamen folgende Laserparameter zum Einsatz: Die Laserwellenlänge beträgt 1064 nm. Es wird keine Pulsung, sondern ein kontinuierlicher Laserstrahl im Dauerstrichbetrieb eingestellt. Der Vorschub des Lasers kann z. B. 500 mm/s betragen und die Leistung auf 4,3 W eingestellt werden.

Alle Ablationen erfolgen von der Glasseite.

### Zweites bis 23. Ausführungsbeispiel:

Es wird an Stelle der genannten 2 %-igen Salzsäure und der Ätzdauer von 100 Sekunden die nachfolgend genannte Säuren und Ätzzeit gewählt:

**Tabelle 1:**

| Ätzlösung | Chemische Summenformel | Konzentration [mol/l] | Ätzdauer [Sekunden] |
|---|---|---|---|
| Salzsäure | HCl | 0,137 mol/l | 300 s |
| Salzsäure | HCl | 0,274 mol/l | 160 s |
| Salzsäure | HCl | 0,548 mol/l | 100 s |
| Salzsäure | HCl | 1,37 mol/l | 35 s |
| Flusssäure | HF | 0,5 mol/l | 330 s |
| Flusssäure | HF | 1,0 mol/l | 170 s |
| Flusssäure | HF | 2,5 mol/l | 70 s |
| Flusssäure | HF | 5,0 mol/l | 35 s |
| Schwefelsäure | H₂SO₄ | 0,1 mol/l | 330 s |
| Phosphorsäure | H₃PO₄ | 1,26 mol/l | 300 s |
| Salpetersäure | HNO₃ | 0,3 mol/l | 120 s |

Es ist zu beachten, dass Schwefelsäure und Salpetersäure relativ starke Oxidationsmittel darstellens. Bei dem erfindungsgemäßen Ätzprozess mit dieser Ätzlösung wird gegebenenfalls nicht nur das Zinkoxid geätzt, sondern es kann auch die Siliziumoberfläche zu SiO₂ oxidiert werden. Diese Schicht kann gegebenenfalls die Funktionsweise des Solarmoduls beeinträchtigen. Es ist daher vorteilhaft, nach einem Ätzschritt mit einem starken Oxidationsmittel einen weiteren Ätzschritt mit Flusssäure (z. B. 1% für 10 s) durchzuführen, um diese SiO₂ Schicht wieder zu entfernen.

Wie aus der Tabelle ersichtlich ist, sind die Konzentrationen und die Ätzzeiten durch einen etwa linearen Zusammenhang gekennzeichnet. Es ist denkbar, daher auch beliebige andere Konzentrationen zu wählen und die Ätzzeiten hieran anzupassen. Dies sind die Ausführungsbeispiele 2-12.

Es ist denkbar, an Stelle des Schritts h) eine Laserablation mit 532 nm zur Entfernung der zweiten elektrischen Kontaktschicht und der Halbleiter-Schichten durchzuführen. Die Serienverschaltung erfolgt sodann nicht durch Aufschmelzen (Schritt h)), sondern durch Auffüllen der so hergestellten dritten Gräben mit elektrisch leitfähigem Kontaktmaterial, z. B. leitfähiger Tinte, umfassend z. B. Silber als Kontaktmaterial mit einem Tintenstrahldrucker. Auf diese Weise wird der Kontakt von der zweiten elektrischen Kontaktschicht eines ersten streifenförmigen photovoltaischen Elements zu der in den Gräben freigelegten ersten elektrischen Kontaktschicht einer zu diesem benachbarten streifenförmigen photovoltaischen Element gebildet. Im Vergleich zu dem Verfahren des Aufschmelzens sind hier die Abstände der Gräben etwas vergrößert, so dass das Verfahren ausgeführt werden kann.

Dies sind die Ausführungsbeispiele 13 bis 24.

Selbstverständlich ist es denkbar, die Ausführungsbeispiele beliebig miteinander zu kombinieren.

## Patentansprüche

1. Verfahren zur Herstellung und Serienverschaltung eines Solarmoduls mit streifenformigen photovoltaischen Elementen über die Länge des Solarmoduls mit den Schritten:
a) auf einem Substrat (1) wird eine erste elektrische Kontaktschicht (2) angeordnet,
b) auf der ersten elektrischen Kontaktschicht (2) werden aktive Halbleiter-Schichten (3) angeordnet,
c) auf den aktiven Halbleiter-Schichten (3) wird eine zweite elektrische Kontaktschicht (4) angeordnet,
d) zur Ausbildung paralleler streifenförmiger photovoltaischer Elemente wird die Oberfläche der ersten elektrischen Kontaktschicht über die Länge des Moduls in Löchern (5) perforationsartig freigelegt,
e) die Schichtenfolge wird einer Ätzlösung ausgesetzt, bei der das Material der ersten elektrischen Kontaktschicht (2) geätzt wird,
f) der Ätzschritt nach Schritt e) wird fortgesetzt, bis erste Gräben (8) zwischen den Halbleiter-Schichten (3) und dem Substrat (1) über die Länge des Moduls ausgebildet sind, wobei die Halbleiter-Schichten unterätzt werden,
g) es werden benachbart und seitlich versetzt parallel zu den ersten Gräben (8) gleich viele zweite Gräben (7) über die Länge des Moduls gebildet, wobei in den zweiten Gräben die Oberfläche der ersten elektrischen Kontaktschicht freigelegt ist,
h) zwischen den ersten Gräben (8) und den zweiten Gräben (7) wird ein elektrischer Kontakt von der zweiten elektrischen Kontaktschicht eines streifenförmigen photovoltaischen Elementes (A) zu der ersten elektrischen Kontaktschicht eines hierzu unmittelbar benachbarten streifenförmigen photovoltaischen Elementes (B) gebildet.

2. Verfahren nach Anspruch 1,
bei dem
die Schritte zur Bildung der zweiten Gräben (7) und zur Bildung des elektrischen Kontakts zwischen der ersten und der zweiten elektrischen Kontaktschicht (6) miteinander vertauscht sind.

3. Verfahren nach einem der vorhergehenden Ansprüche,
**dadurch gekennzeichnet, dass**
die Stegbreite S zwischen zwei Löchern (5) in einer Perforationslinie 2 bis 15 µm beträgt.

4. Verfahren nach einem der vorhergehenden Ansprüche,
**dadurch gekennzeichnet, dass**
eine Ablation in Schritt h) zwischen den ersten und den zweiten Gräben durchgeführt wird, bei der durch Aufschmelzen des Materials der Schichten jeweils ein linienförmiger elektrischer Kontakt (6) über die Länge des Moduls von der zweiten elektrischen Kontaktschicht (4) eines ersten streifenförmigen photovoltaischen Elements (A) zu der ersten elektrischen Kontaktschicht (2) eines unmittelbar benachbarten streifenförmigen photovoltaischen Elements (B) gebildet wird.

5. Verfahren nach einem der vorhergehenden Ansprüche 1 bis 3,
**dadurch gekennzeichnet, dass**
eine Ablation in Schritt h) zwischen den ersten und den zweiten Gräben durchgeführt wird, so dass dritte Gräben zwischen den ersten Gräben und den zweiten Gräben über die Länge des Moduls gebildet werden, in denen die Oberfläche der ersten elektrischen Kontaktschicht freigelegt ist und die dritten Gräben sodann mit elektrisch leitfähigem Kontaktmaterial sodann aufgefüllt werden, so dass der elektrische Kontakt von der zweiten elektrischen Kontaktschicht (4) eines ersten streifenförmigen photovoltaischen Elements (A) zu der ersten elektrischen Kontaktschicht (2) eines benachbarten streifenförmigen photovoltaischen Elements (B) zwischen den ersten und den zweiten Gräben gebildet wird.

6. Verfahren nach Anspruch 1 bis 5,
**gekennzeichnet durch**
Wahl von Flusssäure, Salzsäure oder einer anderen Säure oder Base als nasschemisches Ätzmittel.

7. Verfahren nach einem der vorhergehenden Ansprüche,
**dadurch gekennzeichnet, dass**
für die erste elektrische Kontaktschicht (2) ZnO als Material gewählt wird.

8. Solarmodul mit streifenförmigen photovoltaischen Elementen, umfassend eine Schichtenfolge aus Substrat (1), erster elektrischer Kontaktschicht (2), aktiven Halbleiterschichten (3) und hierauf angeordneter zweiter elektrischen Kontaktschicht (4), **dadurch gekennzeichnet, dass**
die Halbleiterschichten (3) und zweiten elektrischen Kontaktschichten (4) perforationsartig über die Länge des Moduls entfernt sind, die Halbleiter-Schichten (3) nasschemisch unterätzt sind und die unter den Halbleiterschichten (3) gebildeten ersten Gräben (8) Ätzhöfe (9) um die Perforationslöcher (5) herum aufweisen, benachbart und seitlich versetzt parallel zu den ersten Gräben (8) gleich viele zweite Gräben (7) über die Länge des Moduls angeordnet sind, wobei in den zweiten Gräben (7) die Oberfläche der ersten elektrischen Kontaktschicht (2) freigelegt ist, und dass zwischen den ersten Gräben (8) und den zweiten Gräben (7) ein elektrischer Kontakt von der zweiten elektrischen Kontaktschicht (4) eines streifenförmigen photovoltaischen Elements (A) zur ersten elektrischen Kontaktschicht (2) eines hierzu unmittelbar benachbarten streifenförmigen photovoltaischen Elements (B) gebildet ist.

## Claims

1. Method for producing a solar module and connecting it in series with strip type photovoltaic elements over the length of the solar module with the steps:
a) a first electrical contact layer (2) is arranged on a substrate (1),
b) active semiconductor layers (3) are arranged on the first electrical contact layer (2),
c) a second electrical contact layer (4) is arranged on the active semiconductor layers (3),
d) the surface of the first electrical contact layer is exposed over the length of the module in holes (5) like perforations to form parallel strip type photovoltaic elements,
e) the series of layers is exposed to an etching solution, in which the material of the first electrical contact layer (2) is etched,
f) the etching step according to step e) is continued until first troughs (8) are formed between the semiconductor layers (3) and the substrate (1) over the length of the module, in which the semiconductor layers are undercut,
g) the same number of second troughs (7) adjacent and offset to the side parallel to the first troughs (8) are formed over the length of the module, in which the surface of the first electrical contact layer is exposed in the second troughs,
h) an electrical contact is formed between the first troughs (8) and the second troughs (7) from the second electrical contact layer of a strip type photovoltaic element (A) to the first electrical contact layer of a strip type photovoltaic element (B) directly adjacent to it.

2. Method according to claim 1,
in which
the steps for forming the second troughs (7) and for forming the electrical contact between the first and second electrical contact layer (6) are exchanged with each other.

3. Method according to one of the previous claims,
**characterised in that**
the width of the link S between two holes (5) in a perforation line is 2 to 15 µm.

4. Method according to one of the previous claims,
**characterised in that**
an ablation is carried out in step h) between the first and second troughs, in which by melting the material of the layers a line type electrical contact (6) is formed over the length of the module from the second electrical contact layer (4) of a first strip type photovoltaic element (A) to the first electrical contact layer (3) of a directly adjacent strip type photovoltaic element (B).

5. Method according to one of the previous claims 1 to 3,
**characterised in that**
an ablation is carried out in step h) between the first and second troughs so that third troughs are formed between the first troughs and the second troughs over the length of the module, in which the surface of the first electrical contact layer is exposed and the third troughs are then filled with electrically conductive contact material so that the electrical contact is formed between the first and second troughs from the second electrical contact layer (4) of a first strip type photovoltaic element (A) to the first electrical contact layer (2) of an adjacent strip type photovoltaic element (B).

6. Method according to claim 1 to 5,
**characterised by**
selecting hydrofluoric acid, hydrochloric acid or another acid or base as wet chemical etching agent.

7. Method according to one of the previous claims,
**characterised in that**
ZnO is selected as material for the first electrical contact layer (2).

8. Solar module with strip type photovoltaic elements, comprising a layer sequence made of a substrate (1), a first electrical contact layer (2), active semiconductor layers (3) and a second electrical contact layer (4) arranged on this,
**characterised in that**
the semiconductor layers (3) and second electrical contact layers (4) are removed like perforations over the length of the module, the semiconductor layers (3) are undercut with wet chemicals and the first troughs (8) formed under the semiconductor layers (3) have etched halos (9) around the perforation holes (5) and the same number of second troughs (7) are arranged adjacent and offset to the side parallel to the first troughs (8) over the length of the module, in which the surface of the first electrical contact layer (2) is exposed in the second troughs (7) and that an electrical contact is formed between the first troughs (8) and the second troughs (7) from the second electrical contact layer (4) of a strip type photovoltaic element (A) to the first electrical contact layer (2) of a strip type photovoltaic element (B) directly adjacent to it.

## Revendications

1. Procédé pour la fabrication et le montage en série d'un module solaire avec des éléments photovoltaïques en forme de bande sur la longueur du module solaire, avec les étapes suivantes :
a) disposition d'une première couche de contact électrique (2) sur un substrat (1),
b) disposition de couches semi-conductrices actives (3) sur la première couche de contact électrique (2),
c) disposition d'une deuxième couche de contact électrique (4) sur les couches semi-conductrices actives (3),
d) mise à nu de la surface de la première couche de contact électrique, sur la longueur du module, grâce à des trous (5) à la manière de perforations pour la formation d'éléments photovoltaïques en forme de bande parallèles,
e) exposition de la succession de couches à une solution de gravure avec laquelle le matériau de la première couche de contact électrique (2) est gravé,
f) poursuite de l'étape de gravure selon l'étape e) jusqu'à ce que des premières tranchées (8) soient formées entre les couches semi-conductrices (3) et le substrat (1) sur la longueur du module, les couches semi-conductrices étant gravées de manière sous-jacente,
g) formation d'autant de deuxièmes tranchées (7) que de premières tranchées (8) sur la longueur du module, au voisinage desdites premières tranchées et parallèlement de manière décalée latéralement par rapport à celles-ci, la surface de la première couche de contact électrique dans les deuxièmes tranchées étant mise à nu,
h) entre les premières tranchées (8) et les deuxièmes tranchées (7), formation d'un contact électrique de la deuxième couche de contact électrique d'un élément photovoltaïque en forme de bande (A) jusqu'à la première couche de contact électrique d'un élément photovoltaïque en forme de bande (B) directement voisin de celui-ci.

2. Procédé selon la revendication 1,
dans lequel
les étapes pour la formation des deuxièmes tranchées (7) et pour la formation du contact électrique entre les première et deuxième couches de contact électrique (6) sont permutées.

3. Procédé selon l'une des revendications précédentes,
**caractérisé en ce**
**que** la largeur de nervure S entre deux trous (5) dans une ligne de perforation est de 2 à 15 µm.

4. Procédé selon l'une des revendications précédentes,
**caractérisé en ce**
**qu'**une d'ablation est réalisée à l'étape h) entre les premières et deuxièmes tranchées lors de laquelle, en faisant fondre le matériau des couches, on forme respectivement un contact électrique en forme de ligne (6), sur la longueur du module, de la deuxième couche de contact électrique (4) d'un premier élément photovoltaïque en forme de bande (A) jusqu'à la première couche de contact électrique (2) d'un élément photovoltaïque en forme de bande (B) directement voisin.

5. Procédé selon l'une des revendications 1 à 3, **caractérisé en ce**
**qu'**à l'étape h), une ablation entre les premières et deuxièmes tranchées est réalisée, de manière à ce que des troisièmes tranchées soient formées entre les premières tranchées et les deuxièmes tranchées, sur la longueur du module, dans lesquelles la surface de la première couche de contact électrique est mise à nu et les troisièmes tranchées sont ensuite remplies avec un matériau de contact électrique conducteur de manière à ce que le contact électrique soit établi de la deuxième couche de contact électrique (4) d'un·premier élément photovoltaïque en forme de bande (A) jusqu'à la première couche de contact électrique (2) d'un élément photovoltaïque en forme de bande (B) voisin entre les premières et deuxièmes tranchées.

6. Procédé selon les revendications 1 à 5, **Caractérisé**
**par** le choix d'acide fluorhydrique, d'acide chlorhydrique ou d'un autre acide ou base en tant que solution de gravure par voie chimique humide.

7. Procédé selon l'une des revendications précédentes,
**caractérisé en ce**
**que** l'on choisit du ZnO en tant que matériau pour la première couche de contact électrique (2).

8. Module solaire avec des éléments photovoltaïques en forme de bande, comprenant une succession de couches composée d'un substrat (1), d'une première couche de contact électrique (2), de couches semi-conductrices actives (3) et d'une deuxième couche de contact électrique (4) disposée par-dessus,
**caractérisé en ce**
**que** les couches semi-conductrices (3) et les deuxièmes couches de contact électrique (4) sont enlevées à la manière de perforations sur la longueur du module, les couches semi-conductrices (3) sont gravées de manière sous-jacente par voie chimique humide et les premières tranchées (8) formées au-dessous des couches semi-conductrices (3) présentent des couronnes de gravure (9) autour des trous de perforation (5), autant de deuxièmes tranchées (7) que de premières tranchées (8) sont disposées, sur la longueur du module, au voisinage desdites premières tranchées et parallèlement de manière décalée latéralement par rapport à celles-ci, la surface de la première couche de contact électrique (2) dans les deuxièmes tranchées (7) étant mise à nu, et en ce qu'un contact électrique est formé entre les premières tranchées (8) et les deuxièmes tranchées (7), de la deuxième couche de contact électrique (4) d'un élément photovoltaïque en forme de bande (A) jusqu'à la première couche de contact électrique (2) d'un élément photovoltaïque en forme de bande (B) directement voisin de celui-ci.
